Europäisches Patentamt

European Patent Office

Office européen des brevets

(11) Veröffentlichungsnummer: **0 297 161**
**A1**

## EUROPÄISCHE PATENTANMELDUNG

(21) Anmeldenummer: 87109498.3

(22) Anmeldetag: 02.07.87

(51) Int. Cl.⁴: **G03F 7/20 , G02B 27/58**

(43) Veröffentlichungstag der Anmeldung:
**04.01.89 Patentblatt 89/01**

(84) Benannte Vertragsstaaten:
**DE FR GB IT NL**

(71) Anmelder: **PERKIN-ELMER CENSOR ANSTALT**
**Schlossstrasse 5**
**FL-9490 Vaduz(LI)**

(72) Erfinder: **Mayer, Herbert E.**
**Fallsgasse 486**
**FL-9492 Eschen(LI)**

(74) Vertreter: **Hofinger, Engelbert et al**
**Torggler-Hofinger Wilhelm-Greil-Strasse 16**
**A-6020 Innsbruck(AT)**

(54) **Projektionsbelichtungssystem.**

(57) Ein Projektionsbelichtungssystem zur Abbildung einer Maske (2) auf ein mit einer Photoschicht (4) versehenes Substrat (5). Zur Kompensation einer Verringerung der Basisbreiten zwischen den Lackstegen gegen den Bildfeldrand hin, die durch ein zum Bildfeldrand hin abfallendes Modulationsübertragungsvermögen des Projektionsobjektives (2) hervorgerufen ist, ist ein radialer Verlauffilter (13) vorgesehen, der an jeder Stelle die Intensität des durch ihn durchtretenden Lichtes umso weniger abschwächt, je geringer das Modulationsübertragungsvermögen für jene Stelle der Maske (2) ist, die von der genannten Stelle des Verlauffilters (13) aus beleuchtet ist.

Fig. 1

Die Erfindung betrifft ein Projektionsbelichtungssystem mit einer Beleuchtungseinrichtung und einem Projektionsobjektiv zur Abbildung einer in einem Objektfeld angeordneten Maske auf ein mit einer das Bildfeld umfassenden Photolackschicht versehenes Substrat.

Bei allen Arten von Projektionsobjektiven ist das Modulationsübertragungsvermögen, d.h. das Vermögen Hell-Dunkel-Kontraste des Objektfeldes (Maske), gemäß ihrer Intensität und räumlicher Anordnung in eine entsprechende Bildfeldverteilung umzusetzen, nicht über das ganze Bildfeld hin konstant. Meistens fällt das Modulationsübertragungsvermögen zum Rand des Bildfeldes hin ab. Dieses Abnehmen des Modulationsübertragungsvermögens tritt auch bei den besten Objektiven, insbesondere bei hohen Raumfrequenzen (steigender Dichte von Gitterlinien) auf und führt dazu, daß die Photolackschicht an Randstellen des Bildfeldes nicht mehr ausreichend, d. h. nicht mehr so, wie es der Maske entsprechen würde, durchbelichtet werden.

Um auch am Rand eine Durchbelichtung sicherzustellen, war es bisher in der Halbleiterlithographie, bei der ein mit Photolack überzogenes Halbleitersubstrat belichtet wird, üblich, die primär aus der Beleuchtungseinrichtung auf die Maske auftretende Lichtmenge zu erhöhen, also überzubelichten. Diese globale Überbelichtung führt allerdings an Stellen mit hohem Modulationsübertragungsvermögen zu tatsächlicher Überbelichtung, d. h. zu unerwünscht breiten lackfreien Bereichen.

Aufgabe der Erfindung ist es daher, ein Projektionsbelichtungssystem zu schaffen, mit dem im gesamten Bildfeld untereinander gleich breite Basisbreiten zwischen den Lackstegen von untereinander gleich breiten Vorlagen auf der Maske erzeugt werden können. Für die weiteren Verarbeitungsschritte nach dem Belichten und Entwickeln kommt es nämlich im wesentlichen nur auf die Basisbreiten zwischen den Lackstegen an, weil die Weiterbehandlung (z. B. Ätzen mit Säure) nur an den ganz lackfreien Bereichen ansetzt.

Dies wird erfindungsgemäß dadurch erreicht, daß mindestens ein gesonderter, vorzugsweise in der Nähe des Objektfeldes oder an konjugierten Stellen der Beleuchtungseinrichtung angeordneter Verlauffilter vorgesehen ist, der die Intensität des durch ihn durchtretenden Lichtes an jeder Stelle umso weniger abschwächt, je geringer das über das Bildfeld variierende Modulationsübertragungsvermögen des Projektionsobjektives für die der jeweiligen Stelle des Verlauffilters zugeordnete Stelle der abzubildenden Maske ist.

Unter der zugeordneten Stelle der abzubildenden Maske wird dabei jene Stelle verstanden, die von der jeweiligen Stelle des Verlauffilters aus beleuchtet ist. Das vom Projektionsobjektiv und vom Muster der Marke abhängige, über das Bildfeld nicht konstante Modulationsübertragungsvermögen bestimmt den charakteristischen Transmissionsverlauf des Verlauffilters und damit eine entsprechende variierende Bestrahlungsstärke des Objektfeldes. Da das Modulationsübertragungsvermögen im allgemeinen zum Bildfeldrand hin abfällt, wird auch meist ein radialer Verlauffilter mit radial nach außen zunehmendem Transmissionsvermögen zum Einsatz kommen.

Durch das erfindungsgemäße Anordnen von Verlauffiltern braucht das Projektionsobjektiv als solches nicht umgebaut zu werden. Es bleibt daher das im allgemeinen gegen den Rand des Bildfeldes hin schlechtere Modulationsübertragungsvermögen des Projektionsobjektives auch nach dem Anordnen eines Verlauffilters gemäß der Erfindung erhalten. Dennoch kann mit den erfindungsgemäßen Verlauffiltern auf einfache Weise erreicht werden, daß die Bestrahlungsstärke über das Objektfeld so variiert, daß über das gesamte Bildfeld - trotz nach wie vor schlechterem Modulationsübertragungsvermögens am Rande - untereinander gleich breite Basisbreiten zwischen den unbelichteten Lackstegen von untereinander gleich breiten Vorlagen erzeugt werden. Dabei ist es unvermeidlich, daß der Böschungswinkel an den Flanken der Lackstege von der Bildmitte zum Bildrand abnimmt. Dies wird in Kauf genommen.

Neben dem verwendeten Projektionsobjektiv und der abzubildenden Maske, die den qualitativen Transmissionsverlauf des Verlauffilters festlegen, geht noch das Ansprechverhalten der belichteten Photolackschicht bei der quantitativen Dimensionierung des Verlauffilters ein. Es ist daher vorteilhaft, wenn das Ausmaß der Schwächung der Intensität des durch den Verlauffilter durchtretenden Lichtes in Abhängigkeit vom Ansprechverhalten der belichteten Photolackschicht bestimmt ist.

Bei einigen Projektionsbelichtungssystemen werden hintereinander verschiedene Masken abgebildet. Da das Muster der Masken unter anderem auch das Modulationsübertragungsvermögen beeinflußt und damit bei verschiedenen Masken auch verschiedene Verlauffilter zur Kompensation des durch das über das Bildfeld variierende Modulationsübertragungsvermögen hervorgerufenen Effektes nötig sind, dann gemäß einer bevorzugten Ausführungsform der Erfindung vorgesehen sein, daß wenigstens ein Verlauffilter je nach gerade abzubildender Maske austauschbar ist. Es läßt sich auf diese Weise bei unverändertem Projektionsobjektiv für jede Maske eine ideale Belichtung erzielen.

Die Erfindung wird im folgenden anhand von Ausführungsbeispielen durch die Zeichnungen näher erläutert.

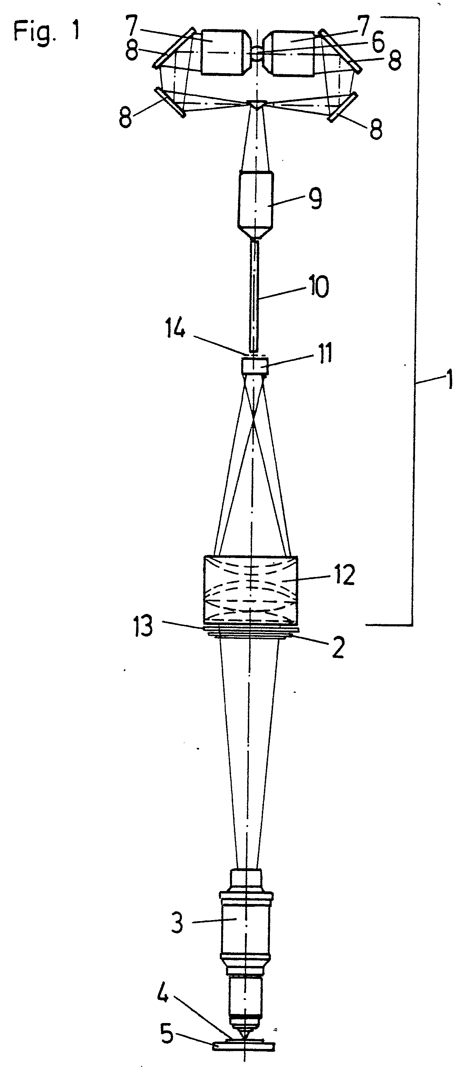

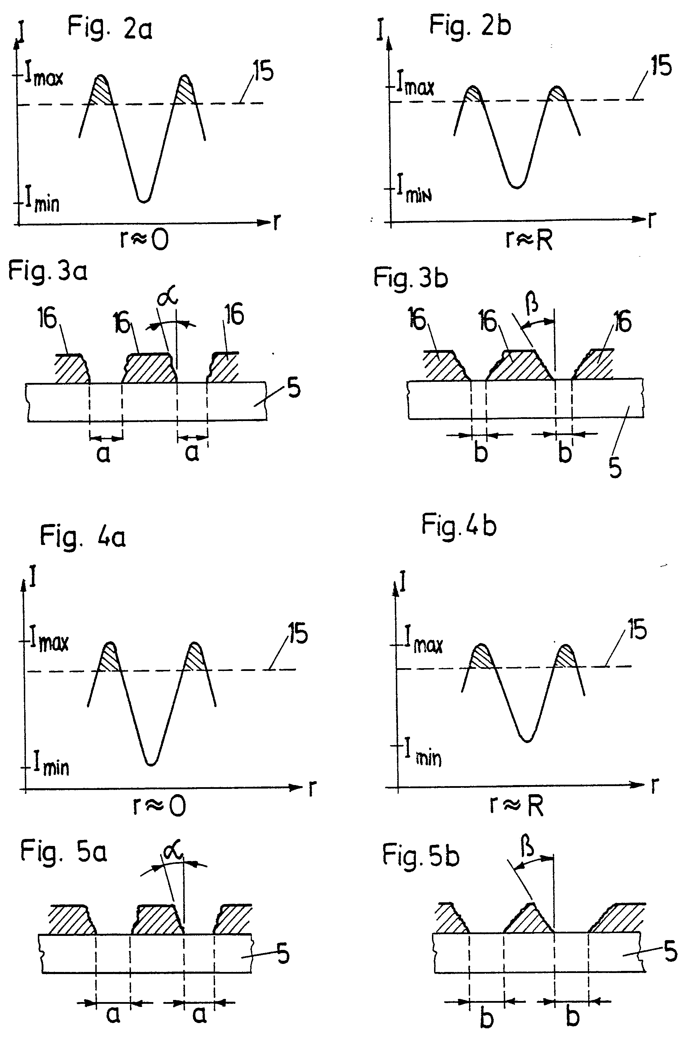

Es zeigen die Fig. 1 eine schematische Ansicht eines erfindungsgemäßen Projwkrionsbelichtungssystems, die Fig. 2a und 2b den Intensitätsverlauf in der Bildfeldmitte bzw. an Bildfeldrand (ohne Verlauffilter), die Fig. 3a und 3b die zugehörigen Lackprofile, die Fig. 4a und 4b die Intensitätsverläufe der Fig. 2a bzw. 2b, jedoch mit eingebrachtem Verlauffilter und die Fig. 5a und 5b die zugehörigen Lackprofile.

Das in Fig. 1 gezeigte Projektionsbelichtungssystem weist eine insgesamt mit 1 bezeichnete Beleuchtungseinrichtung, eine eingesetzte Maske 2 und ein verkleinerndes Projektionsobjektiv 3 auf, um das auf der Maske 2 vorgesehene Muster auf das mit einer positiven Photolackschicht 4 versehene Halbleitersubstrat 5 abzubilden.

Die Beleuchtungseinrichtung 1 weist eine Lampe 6 zur Lichterzeugung auf, von wo aus das Licht über Doppel-Kondensor-System 7 und anschließende Spiegel 8 in eine mit einem Filter, einer Linse und einem Licht-Integrator versehene Einheit 9 gelangt. Über einen Lichtleiter 10, eine Linse 11 und eine Kondensorlinsenanordnung 12 tritt das Licht gleichmäßig verteilt aus der Beleuchtungseinrichtung aus.

Zwischen Beleuchtungseinrichtung 1 und Maske 2 ist der erfindungsgemäße Verlauffilter 13 angeordnet, der im vorliegenden Fall ein radialer Grauverlauffilter mit radial nach außen zunehmenden Transmissionsvermögen ist. Dieser Verlauffilter 13 bewirkt eine über das Objektfeld (Maske 2) variierende Bestrahlungsstärke und kompensiert damit auf die im folgenden noch näher beschriebene Weise das gegen den Bildfeldrand bzw. den Objektfeldrand hin abfallende Modulationsübertragungsvermögen des Projek tionsobjektives 2. Alternativ oder zusätzlich könnte ein Verlauffilter 14 nach dem Lichtleiter 10 angebracht sein.

Den folgenden Figuren 2a bis 5b ist allen ein und dieselbe Maske mit einem Strichgitter und ein Substrat mit einer Photolackschicht bestimmten Anspruchverhaltens zugrunde gelegt.

In den Fig. 2a und Fig. 2b ist der Intensitätsverlauf in der Bildebene dargestellt, und zwar einmal in der Bildmitte ($r = 0$; Fig. 2a) und einmal am Bildrand ($r = R$; Fig.2b), wenn kein Verlauffilter in den Strahlengang eingebracht ist, wenn also ein gleichmäßig beleuchtetes Objektfeld vorliegt. Da am Bildrand das Modulationsübertragungsvermögen des Projektionsobjektives geringer als in der Bildmitte ist, ist der Kontrast $((I_{max} - I_{min})/(I_{max} + I_{min})$ am Bildrand schlechter, wobei auch die maximale Intensität am Bildrand (Fig. 2b) unter der in der Bildmitte (Fig. 2a) liegt. Die "Durchbelichtungsschwelle" für den Photolack ist strichliert eingezeichnet und mit 15 bezeichnet.

Die den Fig. 2a bzw. 2b zugeordneten Lackprofile sind schematisch in den Figuren 3a bzw. 3b dargestellt. Während die Basisbreite a zwischen Lackstegen 16 in der Bildmitte (Fig. 3a) den vorgesehenen Wert hat, ist die Basisbreite b am Bildrand unerwünschterweise geringer. Der unterschiedliche Flankenwinkel $\alpha$ bzw. $\beta$ rührt von den Kontrastunterschieden (Mitte - Rand) her.

Durch Einbringen eines radialen Verlauffilters 13 etwa an der in Fig. 1 gezeigten Stelle und durch gleichzeitige Erhöhung der aus der Beleuchtungseinrichtung 1 gleichmäßig verteilt austretenden Intensität erreicht man zunächst, daß sich die Intensitätsverteilung in der Bildmitte (Fig. 4a) und damit die resultierende Basisbreite a zwischen den Lackstegen 16 (Fig. 5a) nicht ändert.

Dadurch aber, daß der Verlauffilter die Intensität des durch ihn durchtretenden Lichtes am Rand weniger schwächt, weil für diese Stellen das Modulationsübertragungsvermögen des Projektionsobjektives 2 schlechter ist, ist die Bestrahlungsstärke am Objektfeldrand höher. Wie aus Fig. 4b hervorgeht, hat sich durch diese Maßnahme der Kontrast gegenüber der Fig. 2b (ohne Verlauffilter) nicht gebessert. Wohl aber liegt die Intensitätsverteilung am Rand (Fig. 4b) insgesamt höher als in Fig. 2b, also mit mehr Anteilen über der "Durchbelichtungsschwelle 15". Das zugehörige Lackprofil (Fig. 5b) weist die gleiche Basisbreite b auf, wie sie in der Bildmitte (Basisbreite a, Fig. 5a) vorliegt. Der unterschiedliche Flankenwinkel $\alpha$ bzw. $\beta$ wird durch Einbringen des Verlauffilters, der ja das Modulationsübertragungsvermögen und damit den Kontrast an sich nicht verändert, nicht aufgehoben. Wesentlich ist aber, daß in Fig. 5a und 5b die Basisbreiten gleich sind ($a = b$).

Den Transmissionsverlauf des Verlauffilters hängt vom Modulationsübertragungsvermögen des Projektionsobjektives bei einer bestimmten Maske ab. Es ist daher sinnvoll bei verschiedenen Masken auch verschiedene, austauschbare Verlauffilter vorzusehen. Außerdem geht in die quantitative Bemessung des Transmissionsvermögens des Verlauffilters noch das Ansprechverhalten der Photolackschicht ein.

Die Erfindung ist selbstverständlich nicht auf die gezeigten Ausführungsbeispiele beschränkt. Der spezielle Aufbau der Beleuchtungseinrichtung ist nicht erfindungswesentlich. Auch die Auswahl der Verlauffilter und deren Anordnung im Strahlengang kann gegenüber den gezeigten Möglichkeiten durchaus variieren.

## Ansprüche

1. Projektionsbelichtungssystem mit einer Beleuchtungseinrichtung und einem Projektionsobjektiv zur Abbildung einer in einem Objektfeld angeordneten Maske auf ein mit einer das Bildfeld umfassenden Photolackschicht versehenes Substrat, dadurch gekennzeichnet, daß mindestens ein gesonderter, vorzugsweise in der Nähe des Objektfeldes oder an konjugierten Stellen der Beleuchtungseinrichtung angeordneter Verlauffilter vorgesehen ist, der die Intensität des durch ihn durchtretenden Lichtes an jeder Stelle umso weniger abschwächt, je geringer das über das Bildfeld variierende Modulationsübertragungsvermögen des Projektionsobjektives für die der jeweiligen Stelle des Verlauffilters zugeordnete Stelle der abzubildenden Maske ist.

2. Projektionsbelichtungssystem nach Anspruch 1, dadurch gekennzeichnet, daß das Ausmaß der Schwächung der Intensität des durch den Verlauffilter durchtretenden Lichtes in Abhängigkeit vom Ansprechverhalten der belichteten Photolackschicht bestimmt ist.

3. Projektionsbelichtungssystem nach Anspruch 1 oder 2, dadurch gekennzeichnet, daß wenigstens ein Verlauffilter je nach gerade abzubildender Maske austauschbar ist.

Fig. 1

EP 0 297 161 A1

Fig. 2a

Fig. 2b

Fig. 3a

Fig. 3b

Fig. 4a

Fig. 4b

Fig. 5a

Fig. 5b

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | IBM TECHNICAL DISCLOSURE BULLETIN, Band 27, Nr. 10B, März 1985, Seiten 6229-6231, New York, US; "Apodization technique for achieving uniform illumination in storage ring X-ray lithography" * Seite 6230, Abschnitt 2; Figuren 1.1,1.2 * | 1 | G 03 F 7/20 G 02 B 27/58 |
| A | J. OPT. SOC. AM. A, Band 3, Nr. 5, Mai 1986, Seiten 704-715, Optical Society of America; J.P. MILLS et al.: "Effect of aberrations and apodization on the performance of coherent optical systems. II. Imaging" * Zusammenfassung; Seite 714, linke Spalte, Abschnitte 2,3 * | 1 | |
| A | US-A-4 469 407 (COWAN et al.) * Zusammenfassung; Figur 1 * | 1 | |
| A | IBM TECHNICAL DISCLOSURE BULLETIN, Band 24, Nr. 4, September 1981, Seite 1909, New York, US; M.D. LEVENSON: "Digital approximation of soft apodized masks for photolithography generated by vector scanned electron beam lithograph" * Seite 1909, Zeilen 1,2 * | 1 | RECHERCHIERTE SACHGEBIETE (Int. Cl.4) G 03 F 7/00 G 03 B 41/00 G 02 B 27/00 H 01 J 37/00 |
| A | US-A-4 592 648 (TABARELLI et al.) * Zusammenfassung; Figur 1 * | 1 | |

Der vorliegende Recherchenbericht wurde für alle Patentansprüche erstellt

| Recherchenort | Abschlußdatum der Recherche | Prüfer |
|---|---|---|
| DEN HAAG | 29-02-1988 | WITH F.B. |

EPO FORM 1503 03.82 (P0403)